# FASCICULE DE BREVET EUROPEEN

(11) **EP 0 511 057 B1**
(45) Date de publication et mention de la délivrance du brevet: **06.09.1995**
(21) Numéro de dépôt: 92401080.4
(22) Date de dépôt: 17.04.1992
(51) Int. Cl.: H01L 31/0352, G02F 1/015

(54) **Modulateur d'ondes et détecteur optique à puits quantiques**
Wellenmodulator und optischer Detektor mit Quantenpotentialtöpfen
Wave modulator and optical detector with quantum wells

(30) Priorité: 25.04.1991 FR 9105107
(43) Date de publication de la demande: 28.10.1992
(73) Titulaire: THOMSON-CSF, 75008 Paris (FR)
(72) Inventeur: Delacourt, Dominique, F-92045 Paris la Défense (FR); Papuchon, Michel, F-92045 Paris la Défense (FR); Dupont, Emmanuel, F-92045 Paris la Défense (FR); Vojdani, Nakita, F-92045 Paris la Défense (FR)
(74) Mandataire: Guérin, Michel

(56) Documents cités:
- FR-A- 2 637 092
- APPLIED PHYSICS LETTERS, vol. 54, no. 25, 19 juin 1989, NEW YORK, US; pages 2589-2591; J. KHURGIN: 'Electro-optical switching and bistability in coupled quantum wells'
- SUPERLATTICES AND MICROSTRUCTURES, vol. 4, no. 6, 1988, London, GB; pages 737-739; M. PATON et al.: 'A novel asymmetrically coupled quantum well infrared modulator'
- PHYSICAL REVIEW B: CONDENSED MATTER, vol. 40, no. 15, 15 août 1989, New York, US; pages 3028-3031; D.Y. OBERLI et al.: 'Direct measurement of resonant and nonresonant tunneling times in asymmetric coupled quantum wells'
- IEEE JOURNAL OF QUANTUM ELECTRONICS, vol. 25, no. 7, juillet 1989, New York, US, pages 1671-1676; P. F. YUH et al.: 'Large Stark effect for transition from local states to global states in quantum well structures'

## Description

L'invention concerne un modulateur d'ondes électromagnétiques à puits quantiques et un détecteur optique à puits quantiques. Plus particulièrement applicable à la modulation ou à la détection de plusieurs longueurs d'ondes lumineuses.

Le domaine technique dans lequel se situe l'invention est celui des modulateurs d'amplitude et de phase conçus à partir d'effets quantiques dans les semiconducteurs. Pour obtenir cette modulation, on agit en général sur les indices réels et imaginaire d'un matériau traversé par l'onde à moduler. Cette action peut être obtenue, par exemple, grâce à l'application d'un champ électrique responsable d'un effet électro-optique. Dans ce domaine de la modulation, les structures semiconductrices quantiques offrent de nombreuses possibilités, en particulier dans les gammes spectrales associées aux transitions électroniques qui peuvent se produire soit entre niveaux quantiques de bandes différentes, c'est-à-dire entre bande de valence et bande de conduction, soit entre niveaux quantiques de la même bande. Dans ce deuxième cas, les transitions alors appelées intrabandes, sont susceptibles de provoquer des zones de dispersion très marquée du fait des résonances qu'elles mettent en jeu. Une action extérieure qui permet de modifier les conditions dans lesquelles se produisent ces transitions est alors capable de modifier les parties réelle et imaginaire des indices de réfraction des matériaux mis en jeu, dans la gamme spectrale associée à ces transitions. C'est ainsi que l'application d'un champ électrique à un puits quantique semiconducteur, modifie de profil de potentiel de ce puits et conduit à une variation de l'écart énergétique entre les niveaux permis qu'il recèle et offre donc une possibilité de modulation, c'est l'effet Stark tel que décrit dans le document : "Tunable Infrared Modulator and Switch using Stark Shift in Step Quantum Wells" de R.P.G. KARUNASIRS, Y.J. MII and K.L. WANG, IEEE Electron Device Letters, vol. 11, n° 5, May 90.

Pour que les transitions intrabandes qui sont à l'origine des modifications importantes des propriétés optiques des matériaux, se produisent effectivement, il faut que les niveaux quantiques à partir desquelles elles peuvent avoir lieu soient peuplée (par exemple d'électrons dans la bande de conduction). Ainsi l'action sur ce peuplement permet également de modifier les propriétés optiques des matériaux. Pour ce faire, deux options principales sont envisageables. La première consiste à peupler bandes de valence et de conduction par un pompage optique qui permet de faire passer les électrons de la première vers la deuxième. La seconde utilise des moyens électriques tels que l'injection de porteurs. C'est dans cette dernière hypothèse que nous nous plaçons, en cherchant à tirer parti à la fois de cette possibilité d'injection et de l'influence directe des paramètres des puits quantiques sur la localisation spectrale de la dispersion anormale liée aux transitions intrabandes qui se produisent au sein de ces puits.

On connaît un tel modulateur dans la demande de brevet français n° 2 637 092. Le document P.F. YUH et al "Large Stark Effects for transitions from local states to global States in quantum well Strucutres" publié dans IEEE Journal of Quantum Electronics 25 (1989) July, n° 7, pages 1671-1676, concerne une structure à triple puits quantiques couplés.

Partant de cette technique connue l'invention a pour but la réalisation de dispositifs optoélectroniques (modulateurs, détecteurs) fonctionnant à plusieurs longueurs d'ondes.

L'invention concerne donc un modulateur d'onde électromagnétique, du type comprenant :
- une structure semiconductrice comportant une première alternance de couches définissant un premier puits quantique entre une première couche barrière et une deuxième couche barrière, ainsi qu'une deuxième alternance de couches accolée à la première alternance de couches et définissant un deuxième puits quantique, entre la première couche barrière et une troisième couche barrière, couplé au premier puits quantique à travers la première couche barrière
- des moyens de peuplement d'électrons du premier puits quantique, et
- des moyens de commande de l'absorption d'une onde à moduler ;

caractérisé en ce que ladite structure semiconductrice comporte une troisième alternance de couches située de l'autre côté de la deuxième alternance de couches par rapport à la première alternance et définissant un troisième puits quantique, entre la deuxième couche barrière et une quatrième couche barrière, couplé au premier puits quantique à travers la deuxième couche barrière, et en ce que lesdits moyens de commande comportent des moyens propres à appliquer sur commande à la structure un champ électrique perpendiculaire au plan des couches orienté dans un sens ou dans le sens opposé, de façon à peupler soit le deuxième puits soit le troisième puits par transfert de porteurs du premier puits ;
les compositions des puits étant telles que :
- le deuxième puits admet deux niveaux d'énergie dont la différence E₁ correspond à une longueur d'onde d'absorption intrabande λ₁
   telle que hc/λ₁ soit proche de E₁
- et le troisième puits admet deux niveaux d'énergie dont la différence E₂ correspond à une longueur d'onde d'absorption intrabande λ₂ telle que
   hc/λ₂ soit proche de E₂,
   h étant la constante de Plank,
   et c la célérité de la lumière dans le vide.

L'invention concerne également un détecteur d'onde électromagnétique appliquant le modulateur caractérisé en ce que les moyens d'applications d'un champ électrique permettent de polariser la structure dans un sens déterminé pour détecter soit une longueur d'onde soit une autre longueur d'onde, et des moyens de détection de photocourant créé par l'illumination à l'une ou l'autre des deux longueurs d'ondes.

L'idée nouvelle sur laquelle repose l'invention consiste donc, à partir d'un puits central peuplé de porteurs, à injecter ces porteurs selon le sens de la polarisation, dans l'un ou l'autre de deux puits satellites différents disposés de part et d'autre de ce puits central et au sein desquels se produisent des transitions intrabandes. Les deux puits satellites étant différents, on crée une dispersion autour d'une longueur d'onde λ₁ ou λ₂ selon le signe de la polarisation ayant permis l'injection. On peut également diminuer de la même manière, la dispersion à la longueur d'onde λ_{c} correspondant à des transitions se produisant au sein du puits peuplé que l'on vide, et cela grâce à la polarisation, au profit de l'un ou l'autre des deux puits satellites.

Les différents objets et caractéristiques de l'invention apparaîtront plus clairement dans la description qui va suivre et dans les figures annexées qui représentent :
- la figure 1, un diagramme de bande d'énergie d'un dispositif selon l'invention ;
- la figure 2, un exemple de réalisation du dispositif de l'invention ;
- les figures 3 et 4, des diagrammes de bande d'énergie illustrant le fonctionnement du dispositif de l'invention ;
- la figure 5, un diagramme de bande d'énergie d'un dispositif selon l'invention comprenant plusieurs empilements de couches similaires au dispositif de la figure 2 ;
- la figure 6, un exemple de réalisation du dispositif de l'invention fonctionnant avec un faisceau de pompage ;
- la figure 7, un exemple de réalisation détaillé selon l'invention.

Les dessins annexés sont destinés à être incorporés à la présente description et pourront non seulement servir à faire mieux comprendre celle-ci mais aussi contribuer à la définition de l'invention le cas échéant en complément à la description.

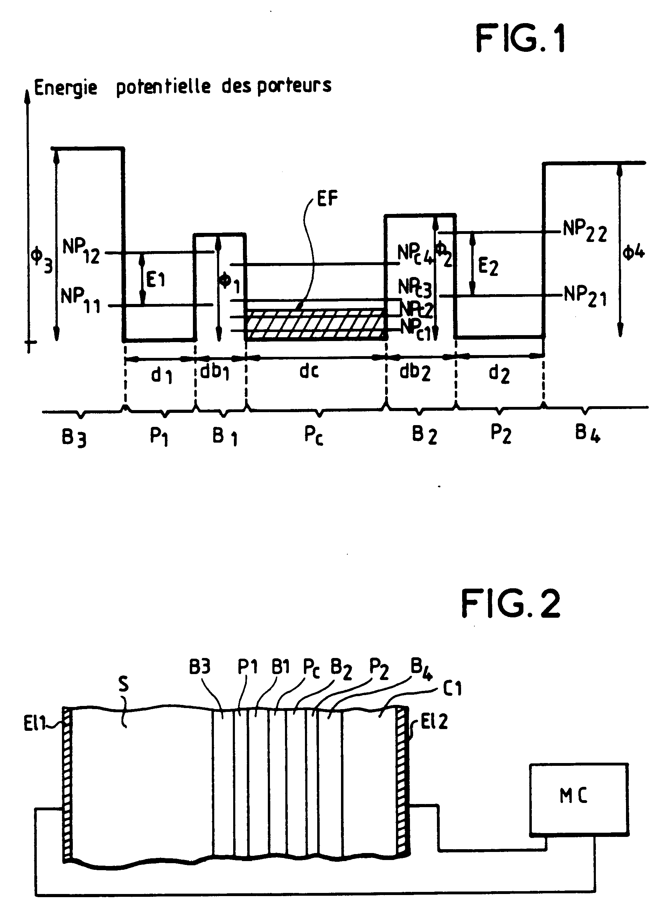

La figure 1 décrit un exemple de configuration quantique qui illustre l'invention et qui est réalisé avec un empilement de couches tels que représenté en figure 2. Le dispositif de la figure 2 comporte sur un substrat S :
- une couche centrale P_{c} encadrée par deux couches barrières B1 et B2 et constituant un premier puits quantique ;
- de part et d'autre des couches barrières B1 et B2, on a deux autres couches de puits quantiques P1 et P2 encadrées par des couches barrières B3 et B4 et définissant respectivement un deuxième et un troisième puits quantique.

La réalisation de ces différentes couches répond aux critères qui vont être décrits en relation avec la figure 1.

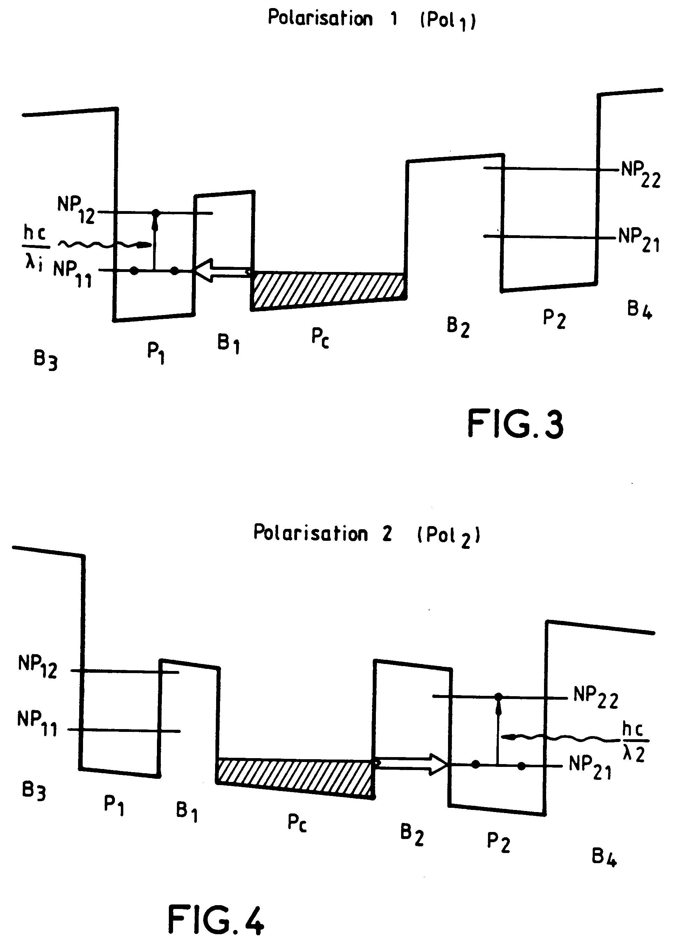

Un puits central Pc dopé, constitue un "réservoir de porteurs". Notons que ces porteurs peuvent être des trous ou des électrons selon que le dopage utilisé est de type N ou P, la figure 1 représentant donc un profil d'énergie potentielle. Deux barrières B1 et B2 séparent ce puits central de deux puits satellites P1 et P2 respectivement, formés également par l'existence des barrières B3 et B4. Les barrières B1 et B2 doivent présenter des paramètres interdisant, en l'absence de polarisation électrique extérieure, le peuplement des puits P1 et P2. Ces puits doivent être conçus de manière à présenter, par exemple, deux niveaux (NP11 et NP12 dans le puits P1 et NP21 et NP22 dans le puits P2), les énergies séparant ces deux niveaux étant différentes dans les deux puits (E1 pour P1 et E2 pour P2). Ces énergies dépendent des épaisseurs d₁ et d₂ des puits mais aussi des dimensions db₁ et db₂ et des hauteurs 0̸₁, 0̸₂, 0̸₃, 0̸₄, des différentes barrières de potentiel. Sur la figure 1 on a également indiqué un exemple de niveau E_{F} de remplissage du puits central et les niveaux NP_{c1}, NP_{c2}, PN_{c3}, NP_{c4}, ... qui peuvent exister au sein de ce puits central Pc. Une polarisation (Pol1) telle que la montre la figure 3, permet de peupler le puits P1 par transfert des porteurs du puits central Pc vers ce puits P1, en particulier grâce à l'effet tunnel au travers de la barrière B1.

Cette polarisation est par exemple appliquée par un générateur de tension MC connecté à des électrodes situées de part et d'autre de la structure (figure 2).

Une polarisation opposée (Pol2) telle que celle illustrée par la figure 4, permet de peupler le puits P2. Sur ces figures 3 et 4 on n'a pas indiqué les niveaux quantiques du puits central, ni précisé l'influence de ces niveaux sur le remplissage des puits P1 et P2. Dans le premier cas (Pol1), on voit apparaître dans le spectre, une dispersion anormale autour de la longueur d'onde λ₁ (λ₁ = hc/E1) et dans le deuxième cas (Pol2) cette modification notable des propriétés optiques intervient autour d'une longueur d'onde λ₂ (λ₂ = hc/E2). Avec :
- h : constante de Plank (h=6,62 10³⁴ J.s)
- c : célérité de la lumière dans le vide (c=3.10⁸m/s)

Donc, en agissant sur le peuplement des puits (P1 et P2, on commande l'occurrence des transitions dans ces puits, et par conséquent l'absorption de photons d'énergie proche de hc/λ₁ dans le puits P1 (figure 3) ou proche de hc/ λ₂ dans le puits P2 (figure 4).

La dispersion anormale qui s'illustre aussi par une variation d'indice de réfraction, peut donc être modulée soit autour de λ₁ si c'est la polarisation Pol1 qu'on module, soit autour de λ₂ si c'est Pol2 qu'on module. On peut également envisager une modulation telle que l'on puisse passer de Pol1 à Pol2 alternativement, en changeant périodiquement le signe de la polarisation obtenue par voie électrique (à l'aide de MC par exemple). Il est important de noter que le caractère résonnant de la dispersion est bien plus marqué dans des puits non dopés peuplés par action externe (par exemple par voie électrique), que dans des puits dopés. En particulier, la largeur à mi-hauteur de l'absorption résonante est beaucoup plus faible dans des puits peuplés par action externe que dans des puits dopés. C'est ce qui a été observé dans des puits GaAs/GaAlAs où un facteur d'environ 3 a été mesuré entre les deux largeurs, ce qui correspond à une absorption au pic trois fois plus grande dans le cas du peuplement sans dopage, ceci pour une même concentration de porteurs mise en jeu. Dans cet exemple les porteurs utilisés étaient les électrons et le dopage de type N. Malgré cela, il peut être intéressant d'utiliser les transitions intrabandes susceptibles de se produire au sein du puits central dopé Pc. On peut alors réaliser un modulateur à trois longueurs d'onde λ₁, λ₂ et λ_{c}, cette dernière valeur correspondant à un écart énergétique entre deux niveaux de ce puits central, impliqués dans des transitions intrabandes. Ainsi, si l'on s'en tient à l'absorption, celle-ci passe de λ_{c} à λ₁ lorsque la polarisation externe passe de 0 à Pol1 et λ_{c} à λ₂ lorsque cette polarisation varie de 0 à Pol2, la modulation à λ_{c} étant obtenue par "vidage" des porteurs du puits central.

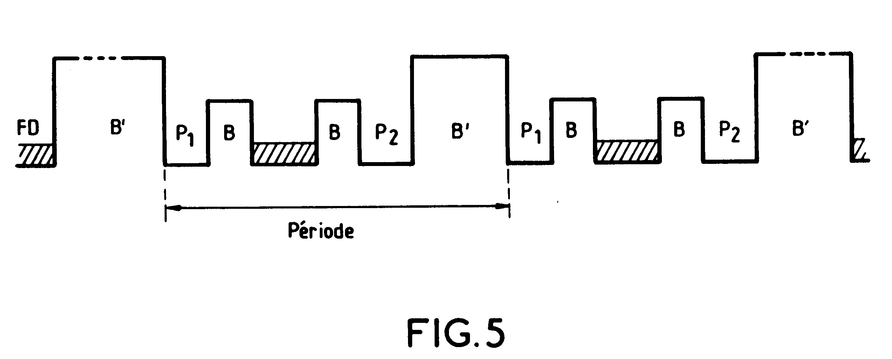

Il est à noter que dans la configuration à deux longueurs d'ondes, la structure est complètement transparente dans la gamme spectrale de travail en l'absence de polarisation, puisque seuls sont actifs au regard des transitions intrabandes les deux puits P1 et P2 non peuplés sans polarisation. Pour augmenter l'efficacité des modulateurs de phase et d'amplitude basés sur la modulation de la polarisation des structures quantiques, il est possible d'associer plusieurs groupes de puits tel que celui représenté sur la figure 1, dans ce cas les barrières B3 et B4 auront en général la même hauteur (0̸₄ = 0̸₃). C'est cette configuration qui est représentée en figure 5, où de plus, et ce uniquement à titre d'exemple, les barrières B équivalentes aux barrières B1 et B2 ont été choisies identiques (0̸₁ = 0̸₂ et db₁ = db₂). Sur la figure 5, on a également représenté des régions extrêmes fortement dopées (RFD) favorisant la réalisation de contacts ohmiques qui peuvent être utilisés pour la polarisation de la structure. Les barrières B′ (équivalentes à B3 et B4) ont été choisies plus hautes que les barrières B afin de limiter la circulation de porteurs le long de la structure, circulation non nécessaire au bon fonctionnement du dispositif mais par contre responsable d'un courant indésirable. Cette configuration où les barrières B′ sont supérieures aux barrières B ne constitue cependant qu'un cas particulier.

A noter également que des transitions peuvent avoir lieu entre un niveau d'un des puits P1, P2 ou Pc et un niveau n'appartenant pas uniquement à ces puits mais réparti dans l'ensemble de la structure P1/B1/Pc/B2/P2 ou encore dans le continuum d'états situé au dessus de la structure globale B3/P1/B1/Pc/B2/P2/B4. Les possibilités de modulation liées à la commande de l'occurrence de ces transitions par modification de la répartition des porteurs entre les trois puits, font également partie de l'invention.

Le peuplement de porteurs du puits central Pc se fait :
- soit par dopage des couches constituant ce puits ;
- soit par pompage optique qui permette de créer des porteurs (électrons dans la bande de conduction et trous dans la bande de valence).

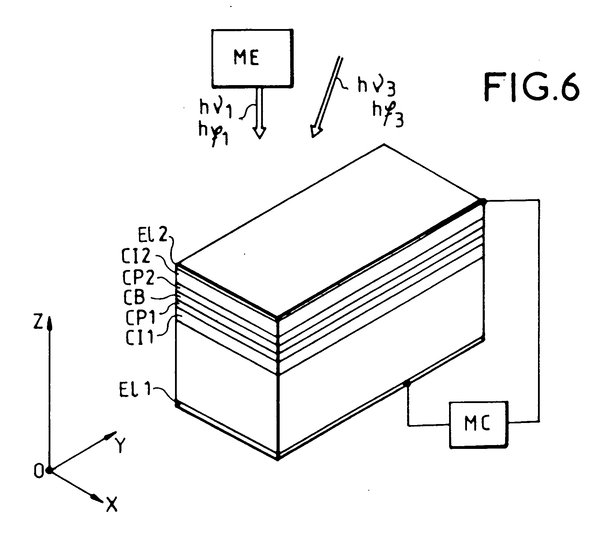

Cette deuxième solution est illustrée en figure 6 où h ν₁ est l'onde de pompe et h ν₃ l'onde à moduler.

Il est à noter que l'onde à moduler pourrait être transmise à la structure parallèlement au plan des couches.

Le dispositif de l'invention permet donc la modulation d'amplitude et de phase à deux ou trois longueurs d'ondes ceci grâce à l'utilisation de puits quantiques semiconducteurs. Ce dispositif permet d'injecter électriquement, à partir d'un puits central peuplé, des porteurs dans l'un ou l'autre de deux puits satellites disposés de part et d'autre de ce puits central. Les paramètres de ces deux puits sont tels que les transitions électroniques ou de trous susceptibles de se produire entre niveaux quantiques et de modifier les propriétés optiques des matériaux (parties réelle et imaginaire de l'indice de réfraction), n'agissent pas à la même longueur d'onde. On réalise ainsi un modulateur, soit à une première longueur d'onde, soit à une deuxième ou bien encore aux deux, selon le signe de la polarisation utilisée pour modifier la répartition des porteurs entre les trois puits. Deux options sont possibles pour le puits central. La première consiste à ne lui faire jouer que le rôle de réservoir de porteurs sans que des transitions intrabandes se produisant en son sein ne viennent modifier les propriétés optiques de la structure dans la gamme spectrale utilisée. Dans ce premier cas, la structure est complètement transparente dans cette gamme en l'absence de polarisation. Dans la deuxième configuration on cherche au contraire à faire se produire au sein du puits dopé des transitions correspondant à la gamme spectrale de travail pour conduire à un modulateur à trois longueurs d'ondes.

La structure de l'invention peut également être appliquée à la détection de rayonnements électromagnétiques. Un détecteur est alors connecté aux bornes de la structure et détecte la circulation d'un courant. Un tel détecteur permet ainsi de détecter trois longueurs d'ondes selon la polarisation électrique appliquée au dispositif.

La structure selon l'invention peut être réalisée de différentes manières en ce qui concerne notamment la constitution, la composition et l'épaisseur des différentes couches

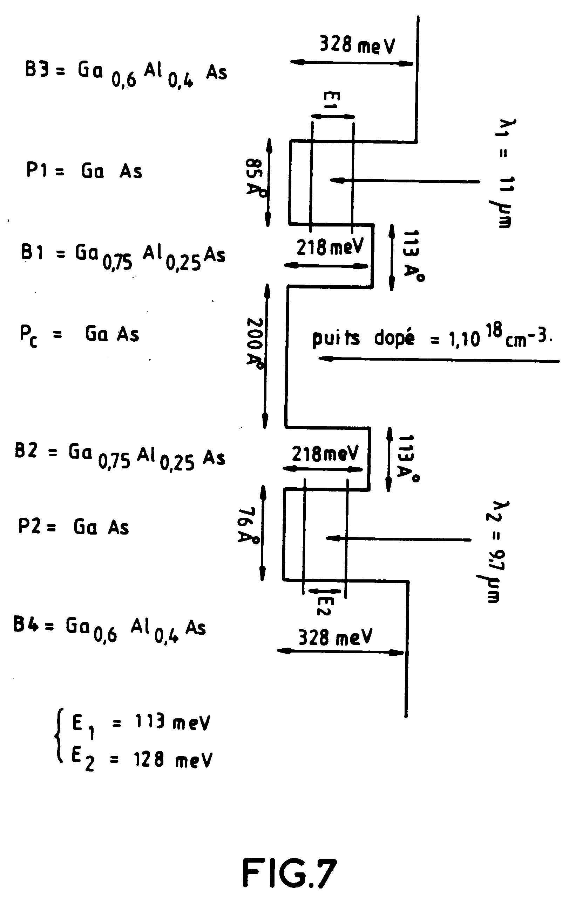

Cependant, à titre d'exemple, on peut indiquer que la structure des figures 1 et 2 peut être réalisée de la manière suivante comme cela est représenté en figure 7 :
- couche barrière B3 :
   - matériau Ga_{0,6}Al_{0,4}As
   - 0̸₃ = 328 meV
- couche de puits quantique P1 :
   - matériau : GaAs
   - épaisseur = 8,5 nm
   - E₁ = 113 meV
- couche barrière B1 :
   - matériau Ga_{0,75}Al_{0,25}As
   - épaisseur = 11,3 nm
   - 0̸₁= 218 meV
- couche de puits quantique P_{C} :
   - matériau GaAs dopé à 1.10¹⁸ cm⁻³
   - épaisseur = 20 nm
- couche barrière B2 :
   - matériau Ga_{0,75}Al_{0,25}As
   - épaisseur = 11,3 nm
   - 0̸₂ = 218 meV
- couche de puits quantique P2 :
   - matériau : GaAs
   - épaisseur = 7,6 nm
   - E₂ = 128 meV
- couche barrière B4 :
   - matériau Ga_{0,6}Al_{0,4}As
   - 0̸₄ = 328 meV

Une telle structure permet de fonctionner aux longueurs d'ondes λ₁ = 11 µm et λ₂ = 9,7 µm.

Il est à noter que les largeurs de bandes interdites des deuxième et troisième puits quantiques peuvent être égales.

De plus, les moyens de peuplement d'énergie (ME) sont actifs sur commande et sont combinés aux moyens de commande (MC) pour permettre une fonction "ET".

Il est bien évident que la description qui précède n'est faite qu'à titre d'exemple non limitatif et que d'autres variantes peuvent être envisagées sans sortir du cadre de l'invention. Notamment en ce qui concerne le nombre de couches et de puits quantiques.

## Revendications

1. Modulateur d'onde électromagnétique, du type comprenant :
- une structure semiconductrice comportant une première alternance de couches (B1, PC, B2) définissant un premier puits quantique (Pc) entre une première couche barrière (B1) et une deuxième couche barrière (B2), ainsi qu'une deuxième alternance de couches (B3, P1, B1) accolée à la première alternance de couches et définissant un deuxième puits quantique (P1), entre la première couche barrière (B1) et une troisième couche barrière (B3), couplé au premier puits quantique à travers la première couche barrière (B1)
- des moyens de peuplement d'électrons du premier puits quantique, et
- des moyens de commande (MC) de l'absorption d'une onde à moduler (E_{F}) ;
caractérisé en ce que ladite structure semiconductrice comporte une troisième alternance de couches (B2, P2, B4) située de l'autre côté de la deuxième alternance de couches par rapport à la première alternance et définissant un troisième puits quantique (P2), entre la deuxième couche barrière (B2) et une quatrième couche barrière (B4), couplé au premier puits quantique à travers la deuxième couche barrière (B2), et en ce que lesdits moyens de commande (MC) comportent des moyens (E11, E12) propres à appliquer sur commande à la structure un champ électrique perpendiculaire au plan des couches orienté dans un sens ou dans le sens opposé de façon à peupler soit le deuxième puits (P1) soit le troisième puits (P3) par transfert de porteurs du premier puits (Pc) ;
les compositions des puits étant telles que :
- le deuxième puits admet deux niveaux d'énergie dont la différence E₁ correspond à une longueur d'onde d'absorption intrabande λ₁
telle que hc/λ₁ soit proche de E₁,
- et le troisième puits admet deux niveaux d'énergie dont la différence E₂ correspond à une longueur d'onde d'absorption intrabande λ₂ telle que
hc/λ₂ soit proche de E₂,
h étant la constante de Plank,
et c la célérité de la lumière dans le vide.

2. Modulateur selon la revendication 1, caractérisé en ce que l'épaisseur et la composition des couches sont telles que le deuxième et le troisième puits quantiques (P1, P2) possèdent chacun une largeur d'énergie de bande interdite différentes de celle du premier puits (Pc).

3. Modulateur selon la revendication 2, caractérisé en ce que les largeurs d'énergie de bandes interdites des deuxième et troisième puits quantiques sont égales.

4. Modulateur selon la revendication 2, caractérisé en ce que les moyens de peuplement d'électrons du premier puits quantique (PC) comportent un dopage de ce puits.

5. Modulateur selon la revendication 2, caractérisé en ce que les moyens de peuplement d'électrons (ME) appliquent à la structure semi-conductrice une onde-pompe, propre au peuplement en porteurs du premier puits quantique (PC) tandis que l'application du champ électrique transfère des porteurs de cedit puits quantique (PC) au deuxième ou troisième puits quantique (P1, P2), ladite absorption intrabande intervenant dans ce deuxième ou troisième puits quantiques.

6. Modulateur selon la revendication 5, caractérisé en ce que les moyens de peuplement d'énergie (ME) sont actifs sur commande et sont combinés aux moyens de commande (MC) pour permettre une fonction "ET".

7. Modulateur selon l'une quelconque des revendications précédentes, caractérisé en ce que le motif des trois puits-quantiques est répété plusieurs fois.

8. Modulateur selon la revendication 1, caractérisé en ce que les moyens (E11, E12) propres à appliquer à la structure un champ électrique sont des contacts ohmiques réalisés de part et d'autre de la structure.

9. Détecteur d'onde électromagnétique appliquant le modulateur selon l'une quelconque des revendications précédentes, caractérisé en ce que les moyens d'applications d'un champ électrique permettent de polariser la structure dans un sens déterminé pour détecter soit la longueur d'onde λ₁ soit la longueur d'onde λ₂, et des moyens de détection de photocourant créé par l'illumination à l'une ou l'autre des deux longueurs d'ondes.

## Patentansprüche

1. Modulator einer elektromagnetischen Welle,
- mit einer Halbleiterstruktur, die eine erste Folge von Schichten (B1, Pc, B2), die eine erste Quantensenke (Pc) zwischen einer ersten Barriereschicht (B1) und einer zweiten Barriereschicht (B2) definiert, sowie eine zweite Folge von Schichten (P3, P1, B1) aufweist, die an die erste Folge von Schichten anschließt und eine zweite Quantensenke (P1) zwischen der ersten Barriereschicht (B1) und einer dritten Barriereschicht (B3) definiert und mit der ersten Senke über die erste Barriereschicht (B1) gekoppelt ist,
- mit Mitteln zur Besetzung der ersten Quantensenke mit Elektronen,
- und mit Steuermitteln (MC) zur Steuerung der Absorption einer zu modulierenden Welle (EF),
dadurch gekennzeichnet, daß die Halbleiterstruktur auf der bezüglich der ersten Folge der zweiten Folge von Schichten gegenüberliegenden Seite eine dritte Folge von Schichten (B2, P2, B4) enthält, die eine dritte Quantensenke (P2) zwischen der zweiten Barriereschicht (B2) und einer vierten Barriereschicht (B4) definiert und mit der ersten Quantensenke über die zweite Barriereschicht (B2) gekoppelt ist, und daß die Steuermittel (MC) Mittel (E11, E12) aufweisen, über die an die Struktur aufgrund einer Steuerung ein elektrisches Feld senkrecht zur Ebene der Schichten in der einen oder der dazu entgegengesetzten Richtung angelegt werden kann, so daß entweder die zweite Senke (P1) oder die dritte Senke (P3) durch Transfer mit Ladungsträgern aus der ersten Senke (Pc) besetzt wird, wobei die Quantensenken so ausgebildet sind,
- daß die zweite Quantensenke zwei Energieniveaus besitzt, deren Differenz E1 einer innerhalb eines Bandes wirksamen Absorption bei einer Wellenlänge λ₁ entspricht, derart, daß hc/λ₁ sehr nahe beim Wert E1 liegt,
- daß die dritte Quantensenke zwei Energieniveaus aufweist, deren Unterschied E2 einer Absorption innerhalb eines Bandes bei einer Wellenlänge λ₂ entspricht, so daß hc/λ₂ dem Wert von E2 sehr nahe kommt, wobei h die Planck'sche Wirkungskonstante und c die Lichtgeschwindigkeit im Vakuum ist.

2. Modulator nach Anspruch 1, dadurch gekennzeichnet, daß die Dicke und der Aufbau der Schichten so gewählt sind, daß die zweite und die dritte Quantensenke (P1, P2) je eine Breite des verbotenen Bands besitzen, die sich von der der ersten Senke (Pc) unterscheidet.

3. Modulator nach Anspruch 2, dadurch gekennzeichnet, daß die Breiten der verbotenen Bänder der zweiten und der dritten Quantensenke einander gleichen.

4. Modulator nach Anspruch 2, dadurch gekennzeichnet, daß die Mittel, mit denen die Besetzung der ersten Quantensenke (Pc) mit Elektronen bewirkt wird, eine Dotierung dieser Senke verwenden.

5. Modulator nach Anspruch 2, dadurch gekennzeichnet, daß die Mittel (ME) zur Besetzung mit Elektronen an die Halbleiterstruktur eine Pumpwelle anlegen, die geeignet ist, die erste Quantensenke (Pc) mit Ladungsträgern zu besetzen, während durch ein elektrisches Feld Ladungsträger von dieser Quantensenke (Pc) zur zweiten oder dritten Quantensenke (P1, P2) transferiert werden, wobei die Absorption innerhalb eines Bandes in der zweiten oder der dritten Quantensenke erfolgt.

6. Modulator nach Anspruch 5, dadurch gekennzeichnet, daß die Mittel (ME) zur Besetzung mit Elektronen aufgrund einer Steuerung wirksam werden und mit den Steuermitteln (MC) so kombiniert werden, daß sich eine UND-Funktion ergibt.

7. Modulator nach einem beliebigen der vorhergehenden Ansprüche, dadurch gekennzeichnet, daß das Motiv der drei Quantensenken mehrfach wiederholt wird.

8. Modulator nach Anspruch 1, dadurch gekennzeichnet, daß die Mittel (E11, E12), mit denen an die Struktur ein elektrisches Feld angelegt wird, ohm'sche Kontakte sind, die zu beiden Seiten der Struktur aufgebracht sind.

9. Detektor für elektromagnetische Wellen, der den Modulator nach einem beliebigen der vorhergehenden Ansprüche verwendet, dadurch gekennzeichnet, daß die Mittel, um ein elektrisches Feld anzulegen, die Struktur in einer bestimmten Richtung vorspannen können, um entweder die Wellenlänge λ₁ oder die Wellenlänge λ₂ zu erfassen und damit den durch Beleuchtung mit Licht der einen oder der anderen der beiden Wellenlängen erzeugten Photostrom zu ermitteln.

## Claims

1. Electromagnetic wave modulator, of the type comprising:
- a semiconductor structure including a first alternation of layers (B1, PC, B2) defining a first quantum well (Pc) between a first barrier layer (B1) and a second barrier layer (B2), as well as a second alternation of layers (B3, P1, B1) adjoining the first alternation of layers and defining a second quantum well (P₁) between the first barrier layer (B1) and a third barrier layer (B3), which well is coupled to the first quantum well across the first barrier layer (B1)
- means of populating the first quantum well with electrons, and
- means of control (MC) of the absorption of a wave to be modulated (E_{F});
characterized in that the said semiconductor structure includes a third alternation of layers (B2, P2, B4) situated on the other side of the second alternation of layers with respect to the first alternation and defining a third quantum well (P₂) between the second barrier layer (B2) and a fourth barrier layer (B4), which well is coupled to the first quantum well across the second barrier layer (B2), and in that the said means of control (MC) include means (E11, E12) capable of applying to the structure, on command, an electric field perpendicular to the plane of the layers and directed in one sense or in the opposite sense, so as to populate either the second well (P₁) or the third well (P₂) by transferring carriers from the first well (Pc);
the compositions of the wells being such that:
- the second well admits two energy levels whose difference E₁ corresponds to an intraband absorption wavelength λ₁
such that hc/λ₁ is close to E₁,
- and the third well admits two energy levels whose difference E₂ corresponds to an intraband absorption wavelength λ₂ such that
hc/λ₂ is close to E₂,
h being Planck's constant,
and c the speed of light in vacuo.

2. Modulator according to Claim 1, characterized in that the thickness and the composition of the layers are such that the second and third quantum wells (P1, P2) each have an energy gap width different from that of the first well (Pc).

3. Modulator according to Claim 2, characterized in that the energy gap widths of the second and third quantum wells are equal.

4. Modulator according to Claim 2, characterized in that the means of populating the first quantum well (PC) with electrons comprise a doping of this well.

5. Modulator according to Claim 2, characterized in that the electron populating (ME) means apply to the semiconductor structure a pump wave capable of populating the first quantum well (PC) with carriers whilst application of the electric field transfers carriers from the said quantum well (PC) to the second or third quantum well (P1, P2), the said intraband absorption intervening in this second or third quantum well.

6. Modulator according to Claim 5, characterized in that the electron populating means (ME) are active upon command and are combined with the control means (MC) to enable an "AND" function.

7. Modulator according to any one of the preceding claims, characterized in that the pattern of the three quantum wells is repeated several times.

8. Modulator according to Claim 1, characterized in that the means (E11, E12) capable of applying an electric field to the structure are ohmic contacts made on either side of the structure.

9. Electromagnetic wave detector applying the modulator according to any one of the preceding claims, characterized in that the means of applying an electric field enable the structure to be polarized in a specified sense in order to detect either the wavelength λ₁, or the wavelength λ₂, and means of detecting photocurrent created by illumination at one or the other of the two wavelengths.
